(19)

**Europäisches Patentamt**
**European Patent Office**
**Office européen des brevets**

(11) **EP 4 151 612 A1**

(12) **EUROPEAN PATENT APPLICATION**

(43) Date of publication:
**22.03.2023 Bulletin 2023/12**

(21) Application number: **22160773.2**

(22) Date of filing: **08.03.2022**

(51) International Patent Classification (IPC):
**C04B 35/584** *(2006.01)* **C04B 35/565** *(2006.01)*
**C04B 35/573** *(2006.01)* **C04B 35/591** *(2006.01)*
**C04B 35/626** *(2006.01)* **C04B 35/645** *(2006.01)*
**C04B 37/02** *(2006.01)* **H01L 23/373** *(2006.01)*

(52) Cooperative Patent Classification (CPC):
**C04B 35/565; C04B 35/573; C04B 35/584;**
**C04B 35/591; C04B 35/6261; C04B 35/6264;**
**C04B 35/62655; C04B 35/645; C04B 37/021;**
**C04B 37/026; H01L 23/15; H01L 23/3735;**
C04B 2235/3206; C04B 2235/3225;
C04B 2235/3826; (Cont.)

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **16.09.2021 JP 2021151507**
**01.02.2022 JP 2022014375**
**04.03.2022 JP 2022033404**

(71) Applicant: **KABUSHIKI KAISHA TOSHIBA**
**Minato-ku**
**Tokyo**
**105-0023 (JP)**

(72) Inventors:
• **Albessard, Keiko**
**Tokyo, 105-0023 (JP)**
• **Yonetsu, Maki**
**Tokyo, 105-0023 (JP)**
• **Harada, Koichi**
**Tokyo, 105-0023 (JP)**
• **Yamashita, Tomohiro**
**Tokyo, 105-0023 (JP)**
• **Suetsuna, Tomohiro**
**Tokyo, 105-0023 (JP)**

(74) Representative: **Hoffmann Eitle**
**Patent- und Rechtsanwälte PartmbB**
**Arabellastraße 30**
**81925 München (DE)**

(54) **COMPOSITE CERAMIC MATERIAL AND JOINED BODY**

(57) A ceramic composite material includes: a silicon nitride grain; and a silicon carbide grain, the silicon nitride grain includes 80% or more β-type silicon nitride, and in a cross section of the ceramic composite material, an average grain size of the silicon nitride grains is not less than 0.1 $\mu$m nor more than 10 $\mu$m. In the cross section, the silicon nitride grain having a grain size three times or more as large as the average grain size has an area proportion of 35% or less to all the silicon nitride grains.

**EP 4 151 612 A1**

(52) Cooperative Patent Classification (CPC): (Cont.)
C04B 2235/3878; C04B 2235/422;
C04B 2235/428; C04B 2235/46;
C04B 2235/5454; C04B 2235/6567;
C04B 2235/658; C04B 2235/666;
C04B 2235/785; C04B 2235/786;
C04B 2235/788; C04B 2235/85; C04B 2235/96;
C04B 2235/9607; C04B 2237/122;
C04B 2237/124; C04B 2237/125;
C04B 2237/365; C04B 2237/368;
C04B 2237/402; C04B 2237/407

**Description**

FIELD

Arrangements described herein generally relate to a ceramic composite material and a combination.

BACKGROUND

Silicon nitride ceramics are used as a material for heat-dissipation substrate because they exhibit excellent properties such as heat dissipation and flexural strength. The amount of heat generation increases as the development of an element such as a power device having high capacity progresses, whereas thermal conductivity and flexural strength of the heat-dissipation substrate material are preferably high because of a demand for weight reduction of mounting devices. Hence, silicon carbide having high thermal conductivity and flexural strength is compounded with silicon nitride. However, such a ceramic composite material has a major axis of a silicon nitride grain as large as 10 $\mu$m or more, thus being disadvantageous to the aspect of flexural strength. On one hand, a proportion of silicon carbide is also as small as 10 mass% or less, and hence the effect of high thermal conductivity which is one of properties of the silicon carbide is not exhibited.

Reference

Reference 1: JPA 8-34671

BRIEF DESCRIPTION OF THE DRAWINGS

FIG. 1 is a cross-sectional schematic view illustrating a structure example of a ceramic composite material.
FIG. 2 is a perspective view exemplifying a ceramic composite material.
FIG. 3 is a perspective view exemplifying a ceramic composite material.
FIG. 4 is a schematic cross-sectional view exemplifying a combination.

DETAILED DESCRIPTION

A ceramic composite material of an arrangement includes: a silicon nitride grain; and a silicon carbide grain, the silicon nitride grain has 80% or more $\beta$ silicon nitride, and in a cross section of the ceramic composite material, an average grain size of a plurality of the silicon nitride grains is not less than 0.1 $\mu$m nor more than 10 $\mu$m. In the cross section, silicon nitride grains having a grain size three times or more as large as the average grain size have an area proportion of 35% or less to all the silicon nitride grains.

Hereinafter, arrangements will be described with reference to the drawings. The drawings are schematic, and for example, the relation between thicknesses and plane dimensions, ratios of the thicknesses of respective layers, and the like may sometimes differ from actual ones. Further, in the arrangements, substantially the same components are denoted by the same reference signs, and a description thereof will be omitted.

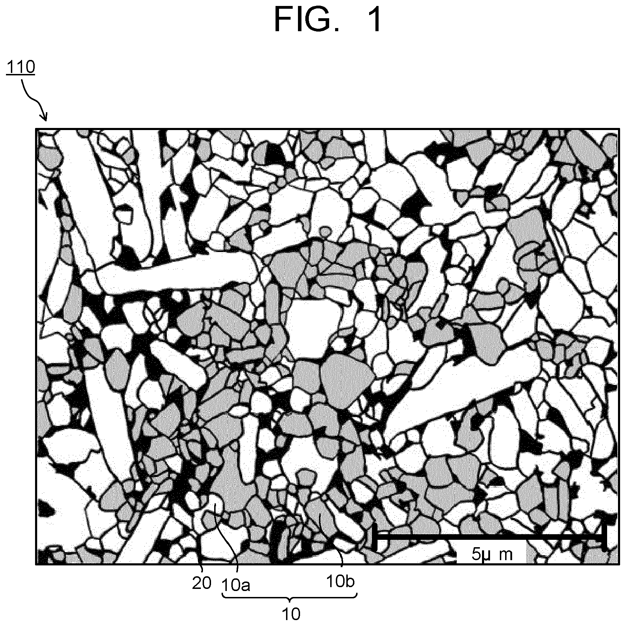

FIG. 1 is a cross-sectional schematic view illustrating a structure example of a ceramic composite material of an arrangement. A ceramic composite material 110 of the arrangement includes a crystal grain 10a, a crystal grain 10b, and a grain boundary 20 provided around the crystal grain 10a and around the crystal grain 10b, as illustrated in FIG. 1. In FIG. 1, black portions show each the grain boundary 20, void grains show each the crystal grain 10a, and gray grains show each the crystal grain 10b. A plurality of crystal grains 10a and a plurality of crystal grains 10b are present in the grain boundaries 20. A plurality of crystal grains 10 including the crystal grain 10a and the crystal grain 10b may be present apart from one another, or may be in partial contact with one another. A part of the plurality of crystal grains 10 may be apart from one another and another part of the plurality of crystal grain 10 may be in partial contact with one another.

Examples of the crystal grain 10a include a silicon nitride grain. A crystal phase of the silicon nitride grain is preferably $\beta$ silicon nitride phase, and preferably does not include $\alpha$ silicon nitride phase. In the whole silicon nitride observed on a measurement surface, a ratio of the $\beta$ silicon nitride is referred to as a $\beta$-phase transformation ratio, which is represented by a formula (1). X-ray diffraction of the ceramic composite material is measured, and from diffraction patterns thereof, in reference to the X-ray diffraction pattern of the $\beta$ silicon nitride (for example, PDF card No. 01-073-3034) and the X-ray diffraction pattern of the $\alpha$ silicon nitride (for example, PDF card No. 01-078-2962), a peak intensity on a (101) surface and a peak intensity on a (120) surface of the $\beta$ silicon nitride, and a peak intensity on a (102) surface and a peak intensity on a (210) surface of the $\alpha$ silicon nitride are read and respectively applied to a $\beta(101)$ intensity, a $\beta(120)$ intensity, an $\alpha(102)$ intensity, and an $\alpha(210)$ intensity in the formula (1).

[Mathematical formula 1]

$$\beta - \text{phase transformation ratio}$$
$$= \frac{\beta(101) \text{ intensity} + \beta(120) \text{ intensity}}{\alpha(102) \text{ intensity} + \alpha(210) \text{ intensity} + \beta(101) \text{ intensity} + \beta(120) \text{ intensity}} \cdots \text{Formula (1)}$$

The $\beta$-phase transformation ratio lower than 80% reduces grains subjected to columnar growth which is a characteristic of the $\beta$ silicon nitride, thereby reducing properties of thermal conductivity and strength. The higher the $\beta$-phase transformation ratio is, the more these properties are improved, and it is preferable that 90% or more silicon nitride is the $\beta$ silicon nitride, that is, the $\beta$-phase transformation ratio is 90% or more, and it is more preferable that the silicon nitride in which the whole $\alpha$ silicon nitride undergoes phase transition to a $\beta$-phase and which the ceramic composite material includes is 100% $\beta$ silicon nitride, that is, the $\beta$-phase transformation ratio is 100%. The $\beta$-phase transformation ratio obtained from the measurement surface is set as the $\beta$-phase transformation ratio of the ceramic composite material.

Examples of the crystal grain 10b include a silicon carbide grain.

The ceramic composite material of the arrangement may include another crystal phase other than the crystal grain 10a and the crystal grain 10b.

The ceramic composite material of this arrangement comprises silicon nitride grains and silicon carbide grains to achieve both high thermal conductivity and high strength.

Ceramics having the silicon nitride grains have high strength, but for example, high-temperature sintering causes the silicon nitride grain to grow to increase a crystal grain size, which is advantageous to thermal conductivity but sometimes decreases the strength.

In contrast to this, the ceramic composite material of the arrangement comprises the silicon nitride grains and the silicon carbide grains to prevent the grain growth of the silicon nitride grain even when the ceramic composite material are manufactured using the high-temperature sintering. This achieves the high strength of the ceramic composite material. Further, the high-temperature sintering enables eliminating oxygen in the crystal phases to increase an amount of a nitrogen rich grain boundary phase. These achieve both the high thermal conductivity and the high strength.

A cross section of the ceramic composite material is observed under the conditions of, for example, an acceleration voltage of 15 kV and a probe current of 10 $\mu$A using Scanning Electron Microscopy-Energy Dispersive X-ray Spectroscopy (SEM-EDS). The cross section may be a fracture surface formed by fracturing a portion of the center of a sintered compact, but is more preferably a cross section subjected to plasma etching by a $CH_4$ gas after mirror-polishing a cut surface of the sintered compact. When the ceramic composite material is incorporated in a combination, the ceramic composite material is taken out of the combination to be mirror-polished, thereafter being subjected to the plasma etching by the $CH_4$ gas to be observed. An observation magnification is set so that 500 crystal grains or more are present in an observation area. Although the observation magnification depends on sizes of the crystal grains, for example, if an average grain size of all the grains is about 2 $\mu$m, the observation area is about 130 $\mu$m $\times$ about 95 $\mu$m and the observation magnification is about 1000 times. Further, if an average grain size of all the grains is about 0.4 $\mu$m, the observation area is about 15 $\mu$m $\times$ about 9 $\mu$m and the observation magnification is about 10000 times, and if an average grain size of all the grains is about 10 $\mu$m, the observation area is about 450 $\mu$m $\times$ about 270 $\mu$m and the observation magnification is about 35 times. The observation areas adjusted in this manner are each prepared at a plurality of points, for example, three points, and average grain sizes and the like are measured regarding the later-described respective observation areas. Average values of the measured results are set as average grain sizes and area proportions of the ceramic composite material according to this arrangement.

A plurality of obtained observation images are analyzed using image-processing software ImageJ. The crystal grain 10a, the crystal grain 10b, and the grain boundary 20 are specified by binarizing the observation images. Further, the silicon nitride grain and the silicon carbide grain are distinguished from the results of the SEM-EDS. Measuring EDS mapping images of cross-sectional images subjected to the SEM observation enables a distinction between the silicon nitride grain and the silicon carbide grain because the grain in which much nitrogen is detected is the silicon nitride grain (crystal grain 10a) and the grain in which much carbon is detected is the silicon carbide grain (crystal grain 10b). The silicon nitride grain, for example, contains 30 atom% or more of nitrogen and 15 atom% or less of carbon, and the silicon carbide grain, for example, contains 15 atom% or less of nitrogen and 35 atom% or more of carbon. The observed cross section is preferably coated by a conductive material except carbon, such as gold or platinum, for the EDS analysis.

A grain size of each grain is defined by a diameter when an area of each grain calculated using the ImageJ is assumed a circle.

In the cross section, an average grain size of the silicon nitride grains calculated from a plurality of fields of view is preferably not less than 0.1 $\mu$m nor more than 10 $\mu$m. When the average grain size is less than 0.1 $\mu$m, thermal conduction is prevented by the grain boundary, in addition to which a proportion of a grain boundary phase having low thermal conductivity increases, which causes the thermal conductivity to decrease. Further, when the average grain size exceeds 10 $\mu$m, a crack easily occurs due to a large surface area, resulting in a decrease in strength.

In the cross section, the silicon nitride grain having a grain size three times or more as large as the average grain size of the silicon nitride grains preferably has an area proportion of 35% or less to all the silicon nitride grains. This reduces a coarse grain having the large surface area, thereby enabling prevention of the decrease in strength. The silicon nitride grain having the grain size three times or more as large as the average grain size more preferably has an area proportion of 20% or less to all the silicon nitride grains. When the silicon nitride grain having the grain size three times or more as large as the average grain size exceeds 35% in an area proportion to all the silicon nitride grains, the coarse grain having the large surface area increases, which brings about the decrease in strength.

In the cross section, all the silicon carbide grains preferably have an area proportion of not less than 1% nor more than 50% to all the grains including all the silicon nitride grains and all the silicon carbide grains. The presence of the silicon carbide grain makes it possible to inhibit the grain growth of the silicon nitride grain and inhibit an increase in the proportion of the silicon nitride grain three times or more as large as the average grain size, thereby allowing the high strength to be maintained. Moreover, the presence of the silicon carbide grain having higher thermal conductivity than that of the silicon nitride grain allows the high thermal conductivity to be achieved. This makes it possible to achieve both the high thermal conductivity and the high strength.

In the cross section, it is preferable that an average aspect ratio of the silicon carbide grain is 2 or less and an average grain size of the silicon carbide grains is not less than 0.1 $\mu$m nor more than 10 $\mu$m. Similarly to the silicon nitride grain, when the average grain size of the silicon carbide grains is less than 0.1 $\mu$m, the thermal conductivity decreases, and when it exceeds 10 $\mu$m, the strength decreases. Hence, falling within the range allows both the high thermal conductivity and the high strength to be achieved.

An aspect ratio of the silicon carbide grain is defined by, after calculating a maximum Feret diameter and a minimum Feret diameter of each grain by the ImageJ, a ratio of the maximum Feret diameter to the minimum Feret diameter.

The grain boundary 20 contains yttrium, silicon, oxygen, and nitrogen. For example, the grain boundary 20 includes an $Y_2Si_3O_3N_4$ crystal phase. The $Y_2Si_3O_3N_4$ crystal phase indicates a crystal having the same crystal structure as a crystal structure of $Y_2Si_3O_3N_4$. Here, the same crystal structure means that crystal systems, space groups, and positional relationships of constituent atoms are the same, and interatomic distances or lattice constants are not necessarily equal. Further, any element may be contained in the crystal phase. That is, the composition of the $Y_2Si_3O_3N_4$ crystal phase may be the same as the composition of the $Y_2Si_3O_3N_4$ crystal, or different from the composition of the $Y_2Si_3O_3N_4$ crystal.

In X-ray diffraction patterns of the ceramic composite material, as represented by a formula (2), a ratio of a maximum peak intensity of the $Y_2Si_3O_3N_4$ crystal phase to peak intensities of the silicon nitride and the silicon carbide is preferably not less than 1% nor more than 15%. This increases the crystal phase having the high thermal conductivity, and thereby the high thermal conductivity can be obtained, as compared with a grain boundary phase constituted of a glass phase.

Conditions for measuring the X-ray diffraction patterns are set as follows, for example. X-ray diffraction is performed by a focusing method (reflection method, Bragg-Brendano method) using an X-ray diffractometer, for example, Smart-Lab manufactured by Rigaku Corporation. In the X-ray diffraction, an arbitrary cross section of the ceramic composite material is used as a measurement surface. The measurement surface is polished to a surface roughness Ra of 0.05 $\mu$m or less. A Cu target (Cu-K$\alpha$) is used for the measurement. A tube voltage is set to 45 kV. A tube current is set to 200 mA. A scanning speed is set to 2.0 to 20.0°/min. An incident parallel slit is set to five degrees, a longitudinal limiting slit is set to 10 mm, a light-receiving slit is set to 20 mm, and a light-receiving parallel slit is set to five degrees. A scanning range (2$\theta$) is set to 10° to 80° and measured in 0.01° increments.

When an X-ray diffraction analysis is performed on a sample of the ceramic composite material, the crystal phase included in the grain boundary phase other than the silicon nitride and the silicon carbide is also detected. The crystal phase is $Y_2Si_3O_3N_4$, and as represented by a formula (2), by normalizing the intensity of its maximum peak with the intensities of the four peaks of the $\beta$ and $\alpha$ silicon nitrides (for absence of the $\alpha$ silicon nitride, the $\alpha$(102) intensity and the $\alpha$(210) intensity are each 0) and an intensity of a maximum peak of the silicon carbide, a peak intensity ratio of $Y_2Si_3O_3N_4$ can be obtained.

[Mathematical formula 2]

$$\text{Peak intensity ratio of } Y_2Si_3O_3N_4 =$$

$$\frac{\text{Maximum peak intensity of } Y_2Si_3O_3N_4}{\frac{\beta(101)\text{intensity} + \beta(120)\text{intensity}}{2} + \frac{\alpha(102)\text{intensity} + \alpha(210)\text{intensity}}{2} + \text{Maximum peak intensity of silicon carbide}} \quad \cdots \text{Formula (2)}$$

The $Y_2Si_3O_3N_4$ crystal phase may further contain magnesium. A concentration of magnesium in the grain boundary phase including the $Y_2Si_3O_3N_4$ crystal phase is preferably 0.01 atom% or more. Containing magnesium is advantageous to good grain growth of the silicon nitride.

Next, an example of a first method for manufacturing the ceramic composite material of this arrangement will be described. The example of the first method for manufacturing the ceramic composite material includes a mixing step, a forming step, and a sintering step.

The mixing step includes mixing a first raw material, a second raw material, and an auxiliary agent to form a mixed powder. These materials can be mixed using a planetary ball mill, for example. The use of the planetary ball mill can grind coarse particles in the first raw material, the second raw material, and the auxiliary agent, to increase uniformity of particle sizes of the mixed powder.

Examples of the first raw material include a powder of silicon and silicon nitride.

Examples of the second raw material and a powder of silicon carbide. An average particle size of the silicon carbide powder is preferably 100 nm or less, but may be several $\mu$m. The silicon carbide powder may have a cubic or hexagonal crystal structure.

Examples of the auxiliary agent include magnesium oxide and yttrium oxide. These auxiliary agent materials may be used independently, or a plurality of them may be mixed and used. The auxiliary agent reacts with surface oxide films of the silicon and the silicon carbide in the sintering step to promote the growth of the silicon nitride grain and the silicon carbide grain, and finally remains as an amorphous phase together with the $Y_2Si_3O_3N_4$ crystal phase in the grain boundary 20.

The mixed powder is preferably mixed and formed so that the silicon nitride and the silicon carbide of not less than 88.5 mass% nor more than 96.5 mass%, the magnesium oxide of not less than 1 mass% nor more than 3.5 mass%, and the yttrium oxide of not less than 2.5 mass% nor more than 8 mass% total 100 mass%. Too small the amount of the auxiliary agent makes the grain growth of the silicon nitride and the silicon carbide difficult, and too large the amount thereof increases the grain boundary phase to reduce thermal conductivity and flexural strength of the ceramic composite material.

The forming step includes pressurizing the mixed powder by a uniaxial press processing to form a compact, and then performing a cold isostatic pressing (CIP) processing on the compact.

When the silicon powder is used as the first raw material, the compact may be processed by nitriding. For example, the compact is processed by heat treatment under a nitrogen atmosphere at 1 atmosphere at temperatures of not less than 1300°C nor more than 1450°C for not less than two hours nor more than eight hours, to change the silicon into silicon nitride in the compact. When the silicon carbide is replaced by carbon, the nitriding causes carbon can changes the silicon into silicon nitride in the compact in similar that the silicon carbide is used, whereas carbon does not react with the silicon in the compact.

The sintering step includes performing heat treatment under a nitrogen atmosphere at not less than 7.5 atmospheres nor more than 10 atmospheres at temperatures of not less than 1800°C nor more than 2000°C for not less than 12 hours nor more than 72 hours, for example, to sinter the compact. The nitrogen atmosphere at not less than 7.5 atmospheres nor more than 10 atmospheres prevent evaporation of the silicon nitride. When the nitriding is before the sintering step, the sintering step is preferably continuously performed without exposing the compact to the air. When the silicon carbide is replaced by carbon, the sintering step enables the silicon nitride to partly react with the carbon to produce silicon carbide.

The sintered compact is shaped into a desired shape by cut-out processing.

The thermal conductivity of the manufactured ceramic composite material is measured in accordance with JIS-R-1611. JIS-R-1611 corresponds to ISO18755 (2005). The thermal conductivity is measured by a laser flash method using a flash analyzer LFA 467 HyperFlash manufactured by Netch Co., Ltd.

The flexural strength of the manufactured ceramic composite material is measured by a three-point flexural strength test in accordance with JIS-R-1601. JIS-R-1601 corresponds to ISO14704 (2000). Autograph AG-X (100 kN) manufactured by Shimadzu Corporation is used for the three-point flexural strength test. A load cell is set to 1 kN, a test speed is set to 0.5 mm/min, and both an indenter radius and a support radius are set to R2, and a distance between supporting points is set to 30 mm, and the test is performed at room temperature.

The thermal conductivity of the ceramic composite material of the arrangement is 70 W/(m· K) or more. An upper limit of the thermal conductivity is, though not particularly limited, for example, 250 W/(m· K) or less.

The flexural strength of the ceramic composite material of the arrangement is 500 MPa or more. An upper limit of the flexural strength is, though not particularly limited, for example, 1100 MPa or less.

The method for manufacturing the ceramic composite material is not limited to the example of the first method example. A second method example for manufacturing the ceramic composite material will be hereinafter described.

The second method example includes a mixing step and a sintering step.

The mixing step includes mixing a first raw material, the second raw material, and the auxiliary agent to form a mixed powder. These materials can be mixed using the planetary ball mill, for example. The use of the planetary ball mill can grind coarse particles in the first raw material, the second raw material, and the auxiliary agent, to increase uniformity of particle sizes of the mixed powder.

Examples of the first raw material include a powder of the silicon nitride. For descriptions of the second raw material and the auxiliary agent, the description of the example of the first manufacturing method can be appropriately quoted.

The mixed powder is preferably mixed and formed so that the silicon nitride and the silicon carbide of not less than 88.5 mass% nor more than 96.5 mass%, the magnesium oxide of not less than 1 mass% nor more than 3.5 mass%, and the yttrium oxide of not less than 2.5 mass% nor more than 8 mass% total 100 mass%. Too small the amount of the auxiliary agent makes the grain growth of the silicon nitride and the silicon carbide difficult, and too large the amount thereof increases the grain boundary phase to reduce the thermal conductivity and the flexural strength of the ceramic composite material.

The sintering step includes performing heat treatment under nitrogen atmosphere pressures of atmospheric pressure to 10 atmospheres at pressing pressures of 20 MPa or more at temperatures of not less than 1800°C nor more than 2000°C using spark plasma sintering (SPS). The heat treatment at temperatures of less than 1800°C or more than 2000°C, and the pressing pressures of less than 20 MPa or less than atmospheric pressure, causes problems such as no densification and no occurrence of the phase transition to the β silicon nitride having high properties. A treatment time is not particularly limited, but for example, more than 3 minutes to 72 hours or less. The treatment time of minutes or less may cause problems such as no densification and no occurrence of the phase transition to the β silicon nitride having high properties. The treatment time more than 72 hours may cause the composite to decompose to disable sintering the compact. The heat treatment can sinter the mixed powder with pressurizing it to requires no forming step. Further, the use of the silicon nitride for the first raw material requires no nitriding. When the silicon carbide is replaced by carbon, a part of the silicon nitride reacts with the carbon to produce silicon carbide through this heat treatment. Further, hot pressing may be replaced by the SPS.

Thereafter, the compact sintered by the SPS, may be processed by a second heat treatment under a nitrogen atmosphere at not less than 7.5 atmospheres nor more than 10 atmospheres at temperatures of not less than 1900°C nor more than 2000°C for not less than 12 hours nor more than 72 hours, for example. The evaporation of the silicon nitride can be prevented by the nitrogen atmosphere at not less than 7.5 atmospheres nor more than 10 atmospheres.

The sintered compact is shaped into a desired shape by the cut-out processing.

The use of the second method example reduces the silicon carbide grain having a grain size three times or more as large as the average grain size of the silicon carbide grains to be an area proportion of 10% or less to all the silicon carbide grains in the cross section. This reduces a coarse grain having the large surface area to prevent the decrease in strength. When the silicon carbide grain having the grain size three times or more as large as the average grain size is larger than 10% in the area proportion to all the silicon carbide grains, the coarse grain having the large surface area increases, which causes the decrease in strength. The silicon carbide grain having the grain size three times or more as large as the average grain size more preferably has an area proportion of 1% or less to all the silicon carbide grains.

The Use of the second method example lowers a ratio of the maximum peak intensity of the $Y_2Si_3O_3N_4$ crystal phase to the intensities of the four peaks of the silicon nitride and the intensity of the maximum peak of the silicon carbide, which is represented by the formula (2) in X-ray diffraction patterns of the ceramic composite material 110, to be 1% or less. The SPS heat treatment before the high-temperature and high-pressure heat treatment in the first method example, can reduce the crystal grain boundary phase having lower thermal conductivity and strength than those of the silicon nitride and the silicon carbide, to improve the thermal conductivity and strength of the ceramic composite material. The SPS moves the grain boundary phase toward a surface of the sintered compact by the pressing pressure during the sintering step, to decrease the grain boundary phase as compared with the high-temperature and high-pressure heat treatment.

In the ceramic composite material 110 formed using the second method example, a c axis of the silicon nitride grain having the grain size three or more times as large as the average grain size of the silicon nitride grains is preferably oriented. The orientation can be evaluated by measuring X-ray diffraction of a surface of the sintered compact subjected to the SPS, for example. This surface of the sintered compact measured by the X-ray diffraction is referred to as a measurement surface. In a diffraction pattern obtained from the measurement surface, in reference to the X-ray diffraction pattern of the β silicon nitride (for example, PDF card No. 01-073-3034), a peak intensity on a (002) surface and a peak intensity on a (320) surface of the β silicon nitride grain are read. From a value found from the following formula (3) and indicating the orientation, a c-axis direction of the β silicon nitride grain relative to the measurement surface can be confirmed, and that the value is smaller means that the c axis of the silicon nitride grain is closer to a parallel state to the measurement surface. It is preferable that the c axis of the silicon nitride grain obtained from at least one measurement surface in the surface of the sintered compact is nonvertical (≠ ±90 degrees) to, further an angle within ±45 degrees from, and further in substantially parallel with the measurement surface. Being substantially parallel includes not only a parallel direction but also a state within ±20 degrees from the parallel direction. Further, the value found from the formula (3) and indicating the orientation is preferably less than 0.5.

[Mathematical formula 3]

$$\text{Orientation} = \frac{\text{Peak intensity on (002) surface of } \beta \text{ silicon nitride grain}}{\text{Peak intensity on (320) surface of } \beta \text{ silicon nitride grain}} \cdots \text{Formula (3)}$$

Since thermal conductivity in a c-axis direction of the silicon nitride grain is high, orienting the c axis of the silicon nitride grain improves the thermal conductivity of the ceramic composite material.

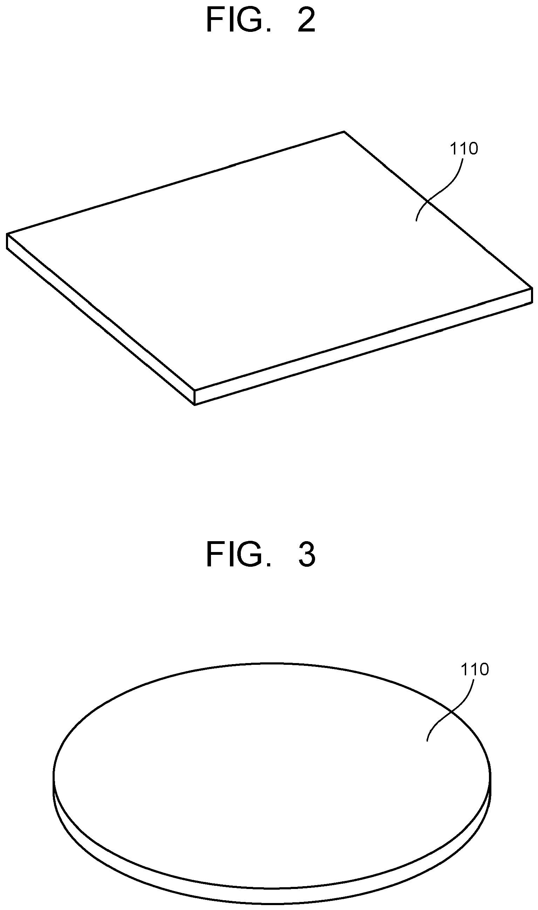

FIG. 2 and FIG. 3 show each a perspective view exemplifying the ceramic composite material of the arrangement.

For example, the ceramic composite material 110 is a substrate as illustrated in FIG. 2 and FIG. 3. A shape of the substrate is optional. As described above, the ceramic composite material of the arrangement has high thermal conductivity and high flexural strength. Hence, the ceramic composite material of the arrangement can be suitably used for the substrate. Alternatively, the ceramic composite material of the arrangement may be a bearing or the like.

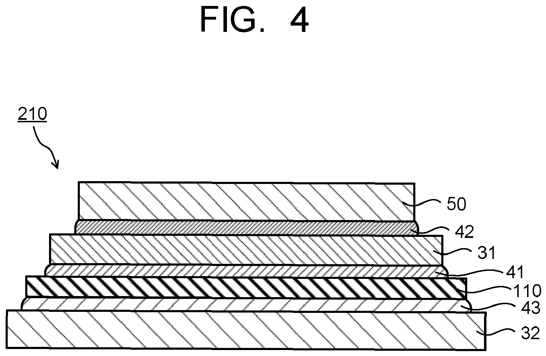

FIG. 4 is a schematic cross-sectional view exemplifying a combination of the arrangement.

A combination 210 of the arrangement includes a first metal part 31 and the ceramic composite material 110, as illustrated in FIG. 4. In this example, the ceramic composite material 110 is used as the substrate.

The first metal part 31 is joined to the ceramic composite material 110. For example, a joint part 41 is provided between the first metal part 31 and the ceramic composite material 110. The first metal part 31 may be directly joined to the ceramic composite material 110 without interposing the joint part 41 therebetween.

In the example illustrated in FIG. 4, the combination 210 further includes a second metal part 32 and a semiconductor device 50. The semiconductor device 50 is joined to the first metal part 31. The first metal part 31 is located between the ceramic composite material 110 and the semiconductor device 50. For example, a joint part 42 is provided between the semiconductor device 50 and the first metal part 31. The semiconductor device 50 may be directly joined to the first metal part 31 without interposing the joint part 42 therebetween.

The second metal part 32 is joined to the ceramic composite material 110. The ceramic composite material 110 is located between the first metal part 31 and the second metal part 32. For example, a joint part 43 is provided between the second metal part 32 and the ceramic composite material 110. The second metal part 32 may be directly joined to the ceramic composite material 110 without interposing the joint part 43 therebetween. The second metal part 32 functions as, for example, a heat sink.

The first metal part 31 and the second metal part 32 contain at least one selected from the group consisting of, for example, copper and aluminum. The joint parts 41 to 43 contain at least one selected from the group consisting of, for example, silver and copper. The joint parts 41 to 43 may further contain at least one selected from the group consisting of titanium, hafnium, zirconium, niobium, silicon, magnesium, indium, tin, and carbon. The semiconductor device 50 includes, for example, a diode, a MOSFET, or an IGBT.

The joint parts 41 to 43 preferably contain an active metal. For example, when the first metal part 31 and the second metal part 32 contain copper, the active metal is at least one selected from the group consisting of titanium, hafnium, zirconium, and niobium. The joint parts 41 to 43 preferably contain silver, copper, and at least one selected from the group consisting of titanium, hafnium, zirconium, and niobium.

When the first metal part 31 and the second metal part 32 contain aluminum, the active metal is at least one selected from the group consisting of silicon and magnesium. The joint parts 41 to 43 preferably contain silver, copper, and at least one selected from the group consisting of silicon and magnesium.

When the first metal part 31 and the second metal part 32 contain copper, the active metal is particularly preferably titanium. Titanium reacts with silicon nitride to form titanium nitride to increase the joining strength.

The use of the ceramic composite material 110 of the arrangement for the combination 210, improves the thermal conductivity and the flexural strength of the combination 210. Further, the use of the ceramic composite material 110 having excellent thermal conductivity for the substrate, for example, improves a heat dissipation property of the substrate. In addition, the ceramic composite material 110 has excellent flexural strength. This allows the substrate to be thinner while maintaining the strength of the substrate. This further improves the heat dissipation property of the substrate.

According to each of the arrangements, it is possible to provide the ceramic composite material and the combination which enable improvement in the thermal conductivity and the flexural strength.

Hereinabove, the arrangements of the present invention have been described with reference to concrete examples. However, the arrangements are not limited to these concrete examples. For example, the concrete configurations of respective elements, such as the ceramic composite material, the metal part, the joint part, and the semiconductor device are included within the scope of the present invention insofar as the present invention can be similarly implemented and the same effects can be achieved by properly selecting the configurations from the range of knowledge available to those skilled in the art.

Further, any two or more elements in each concrete example combined to the extent technically possible are also included within the scope of the present invention insofar as they include the gist of the present invention.

All other ceramic composite materials and joined bodies that can be implemented by those skilled in the art based on the ceramic composite materials and joined bodies described above as the arrangements of the present invention and designed and modified accordingly also fall within the scope of the invention insofar as they include the gist of the present invention.

Within the scope of the present invention, those skilled in the art will be able to come up with various examples of changes and modifications, and it is understood that those examples of changes and modifications are also within the scope of the present invention.

EXAMPLES

Hereinafter, the present invention will be described by citing examples.

(Examples 1 to 3)

A Si powder, a SiC powder, a MgO powder, and an $Y_2O_3$ powder were set in a pot, balls and ethanol were added therein, and then these were kneaded from 60 minutes to 180 minutes using a planetary ball mill at the number of rotations of 300 rpm to 600 rpm, so that slurries were formed. The slurries were distilled and dried to prepare raw material powders. The raw material powders were subjected to uniaxial press forming, were processed by CIP, were processed by nitriding in a nitrogen atmosphere at atmospheric pressure at a temperature of 1450°C for four hours, and then were sintered in a nitrogen atmosphere at 7.5 atmospheres at temperatures from 1800°C to 2000°C from 12 hours to 72 hours, so that ceramic composite materials including silicon nitride and silicon carbide were formed. By appropriately adjusting the number and time of rotations of the planetary ball mill and the temperature and time of the sintering in this manner, average grain sizes of the silicon nitride and coarse grain proportions of the silicon nitride were adjusted.

The ceramic composite materials were processed, and then thermal conductivity and strength were measured. A single surface of each of samples used for the measurement of the thermal conductivity was mirror-polished, and thereafter, by performing plasma etching, samples for cross-section observation were formed. The samples were coated by gold, and then a cross-sectional image illustrated in FIG. 1 was obtained in Example 3 by SEM-EDS, for example. Black portions are grain boundary phases, void grains are silicon nitride grains, and gray grains are silicon carbide grains in this figure.

(Comparative examples 1, 3, 5)

A silicon nitride ceramic material of Comparative example 1 were formed by a method similar to that in Example 1 except that the SiC powder was not added. A silicon nitride ceramic material of Comparative example 3 were formed by a method similar to that in Example 2 except that the SiC powder was not added. A silicon nitride ceramic material of Comparative example 5 were formed by a method similar to that in Example 3 except that the SiC powder was not added.

(Comparative Examples 2, 4)

In Comparative Example 2 as compared with Example 1, the conditions of kneading by using the planetary ball mill were altered to increase the number of rotations and extend the mill time, and the sintering conditions were altered to lower the temperature and shorten the time, and by a method similar to that in Example 1 other than the above, a ceramic composite material was formed. In Comparative Example 4 as compared with Example 2, the conditions of kneading by using the planetary ball mill were altered to decrease the number of rotations and shorten the mill time, and the sintering conditions were altered to increase the temperature and extend the time, and by a method similar to that in Example 2 other than the above, a ceramic composite material including silicon nitride and silicon carbide was formed.

The ceramic composite materials were processed, and then thermal conductivity and strength were measured. A single surface of each of samples used for the measurement of the thermal conductivity was mirror-polished, and then the polished samples were processed by plasma etching, so that samples for cross-section observation were formed. The samples were subjected to gold deposition, and then cross-sectional images were obtained by the SEM-EDS.

Tables 1 to 3 shows the results of performing grain analysis of the cross-sectional images in Examples 1 to 3 and Comparative examples 1 to 5 by the method using ImageJ and the results of the thermal conductivity and the strength. Table 1 shows property results in Example 1 and Comparative examples 1 and 2. Table 2 shows property results in Example 2 and Comparative examples 3 and 4. Table 3 shows property results in Example 3 and Comparative example 5. A coarse grain in each of the tables means a grain having a grain size three or more times as large as an average grain size.

[Table 1]

| Sample | Silicon carbide | Silicon nitride average grain size | Silicon nitride coarse grain proportion | Thermal conductivity (a.u.) | Strength (a.u.) |
|---|---|---|---|---|---|
| Example 1 | Presence | $0.10\mu m$ | 15% | 1.2 | 1 |
| Comparative example 1 | Absence | $0.10\mu m$ | 36% | 1 | 1 |
| Comparative example 2 | Presence | $0.08\mu m$ | 28% | 0.9 | 1.2 |

[Table 2]

| Sample | Silicon carbide | Silicon nitride average grain size | Silicon nitride coarse grain proportion | Thermal conductivity (a.u.) | Strength (a.u.) |
|---|---|---|---|---|---|
| Example 2 | Presence | $10\ \mu m$ | 20% | 1.2 | 1 |
| Comparative example 3 | Absence | $10\ \mu m$ | 57% | 1 | 1 |
| Comparative example 4 | Presence | $12\ \mu m$ | 33% | 1 | 0.9 |

[Table 3]

| Sample | Silicon carbide | Silicon nitride average grain size | Silicon nitride coarse grain proportion | Thermal conductivity (a.u.) | Strength (a.u.) |
|---|---|---|---|---|---|
| Example 3 | Presence | $0.41\ \mu m$ | 19% | 1 | 1.2 |
| Comparative example 5 | Absence | $0.64\ \mu m$ | 37% | 1 | 1 |

As results of performing evaluation and analysis of Examples 1 to 3, average grain sizes of silicon nitride grains fell within a range of 0.1 to 10 $\mu m$, and area proportions of the silicon nitride grains having grain sizes three times or more as large as the average grain sizes were 35% or less to all the silicon nitride grains. Further, an average aspect ratio of each of silicon carbide grains was 2 or less, average grain sizes of silicon carbide grains fell within a range of 0.1 $\mu m$ to 10 $\mu m$, and all the silicon carbide grains fell within a range of area proportions of 10% to 50% to all the grains of all the silicon nitride grains and all the silicon carbide grains. Grain boundary phases each included an $Y_2Si_3O_3N_4$ crystal phase and had a ratio of a maximum peak intensity thereof in X-ray diffraction within a range of 1 to 10% to those of silicon nitride and silicon carbide, and, the grain boundary phases each contained Mg and had a proportion thereof of 0.01 atom% or more.

On the other hand, as results of performing evaluation and analysis of Comparative examples 1, 3, 5, without including silicon carbide, area proportions of silicon nitride grains having grain sizes three times or more as large as average grain sizes were 35% or more to all the silicon nitride grains, grain boundary phases each contained Mg, but an $Y_2Si_3O_3N_4$ crystal phase was not present. Further, as results of performing evaluation and analysis of Comparative examples 2, 4, area proportions of silicon nitride grains having grain sizes three times or more as large as average grain sizes were 35% or less to all the silicon nitride grains, but the average grain sizes of the silicon nitride grains fell outside the range of 0.1 to 10 $\mu$m. Moreover, it is found from Examples 1 to 3 that both high thermal conductivity and high strength can be achieved as compared with Comparative examples 1 to 5.

(Examples 4, 5)

A $Si_3N_4$ powder, the SiC powder, the MgO powder, and the $Y_2O_3$ powder were set in the pot, balls and ethanol were added therein, and then these were kneaded similarly to Examples 1 to 3 using the planetary ball mill, so that slurries were formed. The slurries were distilled and dried to prepare raw material powders. The raw material powders were subjected to heat treatment with SPS under a nitrogen atmosphere having atmospheric pressure at a pressing pressure of 100 MPa at a temperature of 1800°C for more than 3 minutes to 72 hours or less, so that a ceramic composite material including silicon nitride and silicon carbide in Example 4 was obtained.

The sintered compact obtained in Example 4 was further subjected to heat treatment in a nitrogen atmosphere having 7.5 atmospheres at a temperature of 1900°C for more than 3 minutes to 72 hours or less, so that a ceramic composite material including silicon nitride and silicon carbide in Example 5 was obtained.

The ceramic composite materials were processed, and then thermal conductivity and strength were measured. A single surface of each of samples used for the measurement of the thermal conductivity was mirror-polished, and then the polished samples were processed by the plasma etching, so that samples for cross-section observation were formed. The samples were subjected to gold deposition, and then cross-sectional images were obtained by the SEM-EDS.

(Comparative example 6)

The $Si_3N_4$ powder, the SiC powder, the MgO powder, and the $Y_2O_3$ powder were set in the pot, the balls and ethanol were added therein, and then these were kneaded similarly to Examples 4, 5 using the planetary ball mill, so that a slurry was formed. The slurry was distilled and dried to prepare a raw material powder. The raw material powder was subjected to heat treatment with the SPS under a nitrogen atmosphere at atmospheric pressure at a pressing pressure of 100 MPa at a temperature of 1700°C for 3 minutes, so that a ceramic composite material including silicon nitride and silicon carbide in Comparative example 6 was obtained.

The ceramics was processed, and then thermal conductivity and strength were measured. A single surface of a sample used for the measurement of the thermal conductivity was mirror-polished, and then the polished sample was processed by the plasma etching, so that a sample for cross-section observation was formed. This sample was subjected to gold deposition, and then a cross-sectional image was obtained by the SEM-EDS.

Table 4 shows the results of performing grain analysis of the cross-sectional images in Examples 4, 5 and Comparative example 6 by the method using ImageJ, and, values indicating orientations represented by the formula (3) and the measured results of the thermal conductivity and the strength.

[Table 4]

| Sample | Silicon carbide | Silicon nitride average grain size | Silicon nitride coarse grain proportion | Silicon carbide average grain size | Silicon carbide coarse grain proportion | Orientation | Thermal conductivity (a.u.) | Strength (a.u.) |
|---|---|---|---|---|---|---|---|---|
| Example 4 | Presence | 0.43 μm | 5% | 0.36 μm | 0% | 0.37 | 2.1 | 2.0 |
| Example 5 | Presence | 0.51 μm | 12% | 0.47 μm | 1% | 0.38 | 2.1 | 1.9 |
| Comparative example 6 | Presence | 0.26 μm | 3% | 0.08 μm | 0% | 1.16 | 1 | 1 |

As results of performing evaluation and analysis of Examples 4, 5, average grain sizes of silicon nitride grains fell within a range of 0.1 to 10 $\mu$m, and area proportions of the silicon nitride grains having grain sizes three times or more as large as the average grain sizes were 35% or less to all the silicon nitride grains. Further, an average aspect ratio of each of silicon carbide grains was 2 or less, average grain sizes of silicon carbide grains fell within a range of 0.1 to 10 $\mu$m, and area proportions of the silicon carbide grains having grain sizes three times or more as large as average grain sizes of the silicon carbide grains were 10% or less to all the silicon carbide grains. Further, all the silicon carbide grains fell within a range of area proportions of 10% to 50% to all the grains of all the silicon nitride grains and all the silicon carbide grains. Grain boundary phases each included an $Y_2Si_3O_3N_4$ crystal phase and had a ratio of a maximum peak intensity thereof in X-ray diffraction of 1% or less to those of silicon nitride and silicon carbide, and, the grain boundary phases each contained Mg and had a proportion thereof of 0.01 atom% or more. The values indicating the orientations of c axes of the silicon nitride grains represented by the formula (3) were less than 0.5. Hence, it was found that the c axes of the silicon nitride grains in Examples 4, 5 were oriented. Further, as a result of the X-ray diffraction in any of Examples 1 to 5 and Comparative examples 1-5, a silicon nitride crystal phase was 100% $\beta$ silicon nitride.

On the other hand, as a result of performing evaluation and analysis of Comparative example 6, an average grain size of silicon nitride grains fell within a range of 0.1 to 10 $\mu$m, and an area proportion of the silicon nitride grain having a grain size three times or more as large as the average grain size was 35% or less to all the silicon nitride grains. Further, an average aspect ratio of a silicon carbide grain was 2 or less, and an area proportion of the silicon carbide grain having a grain size three times or more as large as an average grain size of the silicon carbide grains was 10% or less to all the silicon carbide grains, but the average grain size was 0.1 $\mu$m or less. Further, all the silicon carbide grains fell within a range of an area proportion of 10% to 50% to all the grains of all the silicon nitride grains and all the silicon carbide grains. A grain boundary phase included an $Y_2Si_3O_3N_4$ crystal phase and had a ratio of a maximum peak intensity thereof in X-ray diffraction of 1% or less to those of silicon nitride and silicon carbide, and, the grain boundary phase contained Mg and had a proportion thereof of 0.01 atom% or more. The value indicating the orientation of a c axis of the silicon nitride grain represented by the formula (3) was 0.5 or more. However, as a result of the X-ray diffraction, a silicon nitride crystal phase was not the required single $\beta$ silicon nitride, but $\alpha$ silicon nitride was mixed by 21% therewith, and hence thermal conductivity and strength were significantly low. Moreover, it is found that both high thermal conductivity and high strength can be achieved in Examples 4, 5 as compared with Comparative example 6.

From the above, the ceramic composite materials in the examples are each the ceramic composite material including the silicon nitride grain and the silicon carbide grain, the silicon nitride grain includes 80% or more $\beta$ silicon nitride, and in the cross section of the ceramic composite material, the average grain size of the silicon nitride grains is not less than 0.1 $\mu$m nor more than 10 $\mu$m. In the cross section, the silicon nitride grain having the grain size three times or more as large as the average grain size of the silicon nitride grains has an area proportion of 35% or less to all the silicon nitride grains, and it has been found that both high thermal conductivity and high strength can be achieved.

While certain arrangements have been described, these arrangements have been presented by way of example only, and are not intended to limit the scope of the inventions. Indeed, the novel arrangements described herein may be embodied in a variety of other forms; furthermore, various omissions, substitutions and changes in the form of the arrangements described herein may be made without departing from the spirit of the inventions. The accompanying claims and their equivalents are intended to cover such forms or modifications as would fall within the scope and spirit of the inventions.

**Claims**

1. A ceramic composite material comprising:

   a silicon nitride grain; and
   a silicon carbide grain,
   wherein the silicon nitride grain has 80% or more $\beta$ silicon nitride,
   wherein in a cross section of the ceramic composite material, an average grain size of a plurality of the silicon nitride grains is not less than 0.1 $\mu$m nor more than 10 $\mu$m, and
   wherein in the cross section, silicon nitride grains having a grain size three times or more as large as the average grain size, have an area proportion of 35% or less to all the silicon nitride grains in the cross section.

2. The ceramic composite material according to claim 1,

   wherein the average grain size is not less than 0.1 $\mu$m nor more than 1.0 $\mu$m, and
   wherein in the cross section, the silicon nitride grains having the grain size three times or more as large as the average grain size, have an area proportion of 20% or less to all the silicon nitride grains.

3. The ceramic composite material according to claim 1 or claim 2, wherein in the cross section, all the silicon carbide grains have an area proportion of not less than 10% nor more than 50% to all the grains of all the silicon nitride grains and all the silicon carbide grains.

4. The ceramic composite material according to any one of claim 1 to claim 3, wherein in the cross section, an average aspect ratio of a plurality of the silicon carbide grains is 2 or less, and an average grain size of the plurality of the silicon carbide grains is not less than 0.1 $\mu$m nor more than 10 $\mu$m.

5. The ceramic composite material according to any one of claim 1 to claim 4, wherein in the cross section, silicon carbides grains having a grain size three times or more as large as an average grain size of a plurality of the silicon carbide grains, have an area proportion of 10% or less to all the silicon carbide grains in the cross section.

6. The ceramic composite material according to claim 5, wherein in the cross section, silicon carbides grains having a grain size three times or more as large as an average grain size of a plurality of the silicon carbide grains, have an area proportion of 1% or less to all the silicon carbide grains in the cross section.

7. The ceramic composite material according to any one of claim 1 to claim 6, further comprising a grain boundary having an $Y_2Si_3O_3N_4$ crystal phase,
wherein the ceramic composite material gives a X-ray diffraction pattern having a ratio of a maximum peak intensity of the $Y_2Si_3O_3N_4$ crystal phase to a peak intensity of silicon nitride and a maximum peak intensity of silicon carbide, the ratio being 1% or less.

8. The ceramic composite material according to any one of claim 1 to claim 7, wherein c axes of the silicon nitride grains having the grain size three times or more as large as the average grain size are oriented to each other.

9. The ceramic composite material according to any one of claim 1 to claim 4, further comprising a grain boundary having an $Y_2Si_3O_3N_4$ crystal phase,
wherein the ceramic composite material gives a X-ray diffraction pattern having a ratio of a maximum peak intensity of the $Y_2Si_3O_3N_4$ crystal phase to peak intensities of silicon nitride and silicon carbide, the ratio being not less than 1% nor more than 15%.

10. The ceramic composite material according to claim 7 or claim 9, wherein the $Y_2Si_3O_3N_4$ crystal phase contains magnesium of 0.01 atom% or more.

11. A combination comprising:

a substrate of the ceramic composite material according to any one of claim 1 to claim 10; and
a first metal part joined to the substrate.

12. The combination according to claim 11, wherein:

the substrate and the first metal part are joined with a first joint part therebetween;
the first metal part contains copper; and
the first joint part contains silver, copper, and at least one selected from the group consisting of titanium, hafnium, zirconium, niobium, silicon, magnesium, indium, tin, and carbon.

13. The combination according to claim 11 or claim 12, further comprising

a second metal part joined to the substrate,
wherein the substrate is located between the first metal part and the second metal part.

14. The combination according to any one of claim 11 to claim 13, further comprising

a semiconductor device joined to the first metal part,
wherein the first metal part is located between the substrate and the semiconductor device.

# FIG. 1

110

20 10a     10b

10

# FIG. 2

110

# FIG. 3

110

# FIG. 4

210

50
42
31
41
110
43
32

Europäisches
Patentamt
European
Patent Office
Office européen
des brevets

# EUROPEAN SEARCH REPORT

Application Number

EP 22 16 0773

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2016 160117 A (NIPPON STEEL & SUMITOMO METAL CORP) 5 September 2016 (2016-09-05) | 1-10 | INV. C04B35/584 |
| Y | * paragraphs [0020] – [0029], [0039] – [0042], [0045] – [0048], [0051], [0052], [0060] – [0064]; claims 1-6; examples 1-5; tables 1, 2 * | 11-14 | C04B35/565 C04B35/573 C04B35/591 C04B35/626 C04B35/645 |
| Y | EP 3 831 799 A1 (TOSHIBA KK [JP]; TOSHIBA MATERIALS CO LTD [JP]) 9 June 2021 (2021-06-09) | 11-14 | C04B37/02 H01L23/373 |
| A | * paragraphs [0078], [0079], [0099]; claims 1-14; figures 3-5 * | 1-10 | |
| A | US 6 133 180 A (MIYAKE KAZUMI [JP] ET AL) 17 October 2000 (2000-10-17) * claims 1-4; examples 1-5 * | 1-14 | |
| A | JP H10 87370 A (HITACHI LTD) 7 April 1998 (1998-04-07) * claims 1-8; figure 1 * | 1-14 | |

TECHNICAL FIELDS SEARCHED (IPC)

C04B
H01L

The present search report has been drawn up for all claims

| Place of search | Date of completion of the search | Examiner |
|---|---|---|
| The Hague | 8 August 2022 | Süzük, Kerem Güney |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

............................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 22 16 0773**

This annex lists the patent family members relating to the patent documents cited in the above-mentioned European search report.
The members are as contained in the European Patent Office EDP file on
The European Patent Office is in no way liable for these particulars which are merely given for the purpose of information.

**08-08-2022**

| Patent document cited in search report | | Publication date | Patent family member(s) | | Publication date |
|---|---|---|---|---|---|
| JP 2016160117 | A | 05-09-2016 | JP | 6354621 B2 | 11-07-2018 |
| | | | JP | 2016160117 A | 05-09-2016 |
| EP 3831799 | A1 | 09-06-2021 | CN | 112313191 A | 02-02-2021 |
| | | | EP | 3831799 A1 | 09-06-2021 |
| | | | JP | WO2020027077 A1 | 26-08-2021 |
| | | | US | 2021122680 A1 | 29-04-2021 |
| | | | WO | 2020027077 A1 | 06-02-2020 |
| US 6133180 | A | 17-10-2000 | JP | H1149572 A | 23-02-1999 |
| | | | US | 6133180 A | 17-10-2000 |
| | | | US | 6261511 B1 | 17-07-2001 |
| JP H1087370 | A | 07-04-1998 | JP | 2829724 B2 | 02-12-1998 |
| | | | JP | H1087370 A | 07-04-1998 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 8034671 A